Europäisches Patentamt

European Patent Office

Office européen des brevets

(11) Numéro de publication: **0 355 922 B1**

(12) **FASCICULE DE BREVET EUROPEEN**

(45) Date de publication de fascicule du brevet: **16.06.93**  (51) Int. Cl.5: **H03K 3/295**

(21) Numéro de dépôt: **89202109.8**

(22) Date de dépôt: **17.08.89**

(54) Circuit d'entrée à commutation accélérée.

(30) Priorité: **19.08.88 FR 8811033**

(43) Date de publication de la demande:
**28.02.90 Bulletin 90/09**

(45) Mention de la délivrance du brevet:
**16.06.93 Bulletin 93/24**

(84) Etats contractants désignés:
**DE FR GB IT NL**

(56) Documents cités:
**EP-A- 0 192 907**
**US-A- 3 646 361**

**IEEE JOURNAL OF SOLID-STATE CIRCUITS,
vol. SC-17, no. 6, décembre 1982, IEEE, New
York, US; E.J. DICKES et al.: "A graphical
analysis of the Schmitt trigger circuit"**

**PATENT ABSTRACTS OF JAPAN, vol. 11, no.
117 (E-498)[2564], 11 avril 1987, page 159 E
498; & JP-A-61 264 910 (FUJITSU LTD)
22-11-1986**

**ELEKTRONIK, vol. 35, no. 12, 13 juin 1986,
page 120; H. PELKA:
"Schmitt-Trigger-Inverter mit einstellbarer
Hysterese"**

(73) Titulaire: **PHILIPS COMPOSANTS
117, quai du Président Roosevelt
F-92130 Issy les Moulineaux(FR)**
(84) Etats contractants désignés:
**FR**

(73) Titulaire: **N.V. Philips' Gloeilampenfabrieken
Groenewoudseweg 1
NL-5621 BA Eindhoven(NL)**
(84) Etats contractants désignés:
**DE GB IT NL**

(72) Inventeur: **Barbu, Stéphane
Société Civile S.P.I.D. 209 rue de l'Université
F-75007 Paris(FR)**

(74) Mandataire: **Charpail, François et al
Société Civile S.P.I.D. 156, Boulevard Haussmann
F-75008 Paris (FR)**

Rank Xerox (UK) Business Services
(3.10/3.6/3.3.1)

**Description**

L'invention concerne un circuit d'entrée de commutation présentant un étage du type à émetteurs couplés (ECL) à deux transistors, le premier recevant sur sa base un signal d'entrée et le deuxième recevant sur sa base un signal de commande, lequel est élaboré par un circuit de commande à partir du signal du collecteur du premier transistor, de manière à obtenir sur le collecteur du deuxième transistor un signal de sortie commutant plus rapidement que le signal d'entrée, dans lequel le circuit de commande comporte un troisième transistor dont le collecteur est connecté à une source de tension d'alimentation, dont la base est connectée au collecteur du premier transistor et dont l'émetteur est reliée à une source de courant de référence dite source principale de courant, via une résistance d'émetteur dite première résistance.

Un tel circuit, utilisé pour compenser le ralentissement de commutation dû à des lignes d'entrée fortement capacitives, est connu du document JP-A-61-264909 (Patent Abstracts of Japan, Vol 11, n° 117 (E-498), 11 avril 1987, p.159 E 498) dans lequel le point commun entre la résistance d'émetteur et la source principale de courant est relié à la base du deuxième transistor. Lorsque par exemple la tension E passe d'un état bas à un état haut, la mise en conduction du premier transistor entraîne la baisse de la tension sur la base du deuxième transistor, ce qui accélère la commutation. Ce phénomène est le même, en sens inverse, pour une transition du signal E d'un état haut à un état bas. La dépendance directe entre la tension de commande et le signal du collecteur du premier transistor fait qu'il n'est pas possible de choisir tous les paramètres de fonctionnement.

La présente invention propose un circuit d'entrée du type précité dans lequel la valeur et l'amplitude de la tension de commande peuvent être choisies.

Ce but est atteint, selon l'invention, par les moyens décrits dans la revendication 1.

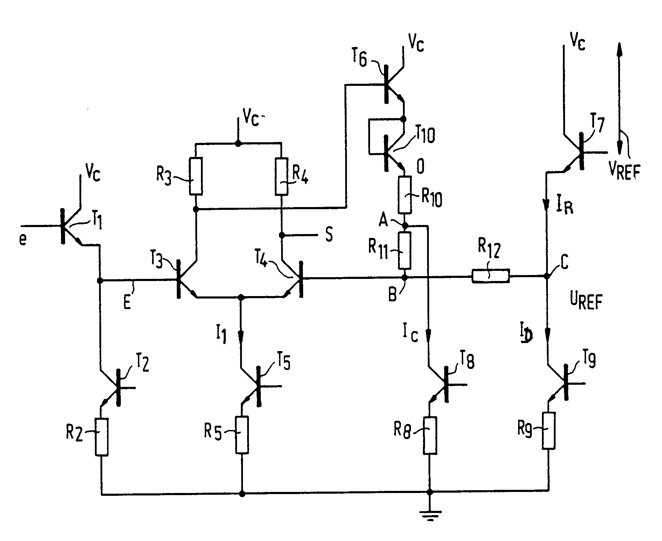

L'invention sera mieux comprise à la lecture de la description qui va suivre en liaison avec la figure unique qui représente le mode de réalisation préféré de l'invention.

Le circuit comporte un étage suiveur d'entrée comportant un transistor $T_1$ recevant sur sa base des signaux d'entrée e, et produisant sur un émetteur des signaux E, cet émetteur étant connecté de manière classique à une source de courant $(T_2,R_2)$. Cet étage tampon est classique et n'a qu'une fonction facultative de découplage. Le circuit d'entrée proprement dit comporte une porte du type à émetteurs couplés (ECL) comprenant deux transistors $T_3$ et $T_4$ dont les émetteurs couplés sont connectés à une source de courant $(R_5,T_5)$ d'intensité $I_1$. Les collecteurs des transistors $T_3$ et $T_4$ sont reliés à une source de tension d'alimentation $V_c$ à travers des résistances respectivement $R_3$ et $R_4$. La base du transistor $T_3$ reçoit le signal E de l'émetteur du transistor $T_1$. Le signal de sortie S est celui fourni par le collecteur du transistor $T_4$, le collecteur du transistor $T_3$ fournissant le signal complémentaire $\overline{S}$.

La tension de base du transistor $T_4$ est déterminée à partir de la tension de collecteur du transistor $T_3$.

La base d'un transistor $T_6$ est connectée au collecteur du transistor $T_3$. Le collecteur du transistor $T_6$ est connecté à une tension de tension d'alimentation $V_c$, et son émetteur est relié à un point C à travers trois résistances en série respectivement $R_{10}$, $R_{11}$ et $R_{12}$, une diode en direct $T_{10}$ étant éventuellement intercalée entre l'émetteur du transistor $T_6$ et la résistance $R_{10}$ de manière à réaliser une compensation de niveau. Le point A commun aux résistances $R_{10}$ et $R_{11}$ est connecté à une source de courant $(R_8,T_8)$ d'intensité $I_c$. Le point B commun aux résistances $R_{11}$ et $R_{12}$ est connecté à la base du transistor $T_4$, éventuellement à travers une résistance. Le point C précité, autre extrémité de la résistance $R_{12}$ est connecté à une source de tension de référence $U_{REF}$. Cette source de tension de référence comporte un transistor $T_7$ dont le collecteur est connecté à la source de tension d'alimentation $V_c$, dont la base reçoit une tension de référence $(V_c-V_{REF})$, et dont un émetteur est connecté au point C ainsi qu'à une source de courant $(R_9,T_9)$ d'intensité $I_D$. Ce courant $I_D$ assure que notamment ledit émetteur soit toujours traversé par un courant $I_R$, de telle sorte que l'on ait toujours :

$$U_{REF} = V_c - V_{REF} - V_{BE}$$

$V_{BE}$ désignant la tension base-émetteur d'un transistor, soit environ 0,7V.

On peut distinguer trois états principaux. Lorsque le signal d'entrée E est au niveau bas (premier état), le transistor $T_3$ est bloqué et le collecteur du transistor $T_3$ est à la tension $V_c$. Lorsque le signal E est au niveau haut (deuxième état), le transistor $T_3$ est passant et le collecteur du transistor $T_3$ est à la tension $V_c-\Delta V$ avec :

$$\Delta V = R_3 I_1$$

Cette valeur $\Delta V$ de l'amplitude de commutation est fixée par les normes définissant le circuit (800mV pour de l'ECL).

Le troisième état est un état d'équilibre transitoire.

Dans le premier état (E au niveau bas), la tension sur l'émetteur du transistor $T_{10}$ (point 0) est au niveau haut qui est supérieur à la tension au point C et la totalité du courant $I_c$ passe à travers la résistance $R_{10}$. Dans le deuxième état (E au niveau haut), la tension au point 0 est au niveau bas qui est inférieur à la tension au point C, la tension au point A est inférieure à celle au point C et le courant $I_c$ se divise entre les deux branches $R_{10}$ et ($R_{11}$, $R_{12}$). C'est ce qui permet d'effectuer un réglage de l'amplitude de variation de tension sur la base du transistor $T_4$ et donc d'utiliser le circuit d'entrée pour des valeurs différentes de $\Delta V$.

Dans le troisième état, les tensions au point A et au point C sont égales, il n'y a pas de courant dans la branche ($R_{11}$, $R_{12}$) et la tension au point B a donc la valeur $U_{REF}$, qui doit, pour un fonctionnement symétrique, être égale à la valeur $E_0$ du signal d'entrée E à mi-pente.

On a dans ce cas :

$$E_0 = U_{REF} = V_c - V_{REF} - V_D$$

d'où on déduit la valeur de $V_{REF}$

$$V_{REF} = V_c - V_D - E_0$$

On va maintenant décrire un mode de calcul des élément du circuit permettant d'obtenir en fonctionnement symétrique.

Pour un fonctionnement symétrique, on choisit que le circuit soit dans le troisième état pour une demi-amplitude de commutation soit :

$$\overline{S} = V_c - \frac{\Delta V}{2}$$

La relation d'équilibre s'écrit alors :

$$V_c - \frac{\Delta V}{2} - V_D - V_{BE6} - R_{10}I_c = U_{REF} = V_c - V_{REF} - V_{BE7}$$

avec

$V_D$ : chute de tension dans une diode
$V_{BE6}$ : tension base-émetteur du transistor $T_6$
$V_{BE7}$ : tension base-émetteur du transistor $T_7$

Les transistors $T_6$ et $T_7$ étant traversés respectivement par $I_c$ et $I_D$, ($I_R = I_D$), on obtient la première condition :

$$R_{10}I_c = V_{REF} - \frac{\Delta V}{2} - V_D + V_T \, \text{Log} \, \frac{I_D}{I_c} \qquad (1)$$

On a tout intérêt à choisir $I_c = I_D$, d'où :

$$R_{10}I_c = V_{REF} - \frac{\Delta V}{2} - V_D \qquad (2)$$

d'où :

$$R_{10}I_c = V_c - 2V_D - E_0 - \frac{\Delta V}{2} \qquad (2')$$

Dans le premier état, on a (en écrivant l'égalité des tensions au point A)

$$V_c - (V_{BE6} + V_D + I_{10}R_{10}) = V_c - V_{REF} - V_{BE7} + I_{11}(R_{11} + R_{12})$$

$I_{11}$ désignant le courant traversant les résistances $R_{11}$ et $R_{12}$.
Soit $V_{BE6} + V_D + I_{10}R_{10} + I_{11}(R_{11} + R_{12}) = V_{REF} + V_{BE7}$

et

$$I_{10} = I_c + I_{11} \; ; \; I_{11} + I_R = I_D$$

D'où :

$$V_{BE6} + V_D + (I_c + I_D - I_R)R_{10} + (I_D - I_R)(R_{11} + R_{12}) = V_{REF} + V_{BE7}$$

Les transistors $T_6$ et $T_7$ étant parcourus par des courants égaux respectivement à $I_c + I_D - I_R$ et $I_R$, on obtient la deuxième condition.

$$V_{REF} = V_T \, Log \frac{I_c + I_D - I_R}{I_R} + V_D + (I_c + I_D - I_R) \, R_{10} + (I_D - I_R)(R_{11} + R_{12})$$

On peut choisir le rapport n entre $I_D$ et $I_R$, soit par exemple 2.
On a alors pour $n = 2$ et $I_c = I_D$

$$V_T Log \; 3 + V_D + (\frac{3}{2} R_{10} + \frac{R_{11} + R_{12}}{2}) I_c = V_{REF}. \qquad (4)$$

Dans le deuxième état, le courant $I_{11}$ circule dans l'autre sens et le courant $I_c$ se divise entre $R_{10}$ d'une part et $R_{11}$ et $R_{12}$ d'autre part :

$$V_c - \Delta V - (V_{BE6} + V_D + I_{10}R_{10}) = V_c - V_{REF} - V_{BE7} - I_{11}(R_{11} + R_{12})$$

soit

$$\Delta V + V_{BE6} + V_D + I_{10}R_{10} = V_{REF} + V_{BE7} + I_{11}(R_{11} + R_{12}).$$
$$I_{10} + I_{11} = I_c$$
$$I_R = I_D + I_{11}$$

d'où :

$$V_{REF} = \Delta V + V_T \, Log \frac{I_c + I_D - I_R}{I} + V_D + (I_c + I_D - I_R)R_{10}$$

$$+ (I_R - I_D)(R_{11} + R_{12}) \qquad (5)$$

où $I_R$ a une valeur différente de celle du premier état.
On choisit

$$I_{11} = \frac{I_c}{2}$$

4

d'où la troisième condition :

$$\Delta V + V_T \, \mathrm{Log} \frac{I_C}{I_C + 2 I_D} + V_D + \frac{R_{10} - (R_{11} + R_{12})}{2} \, I_C = V_{REF} \qquad (6)$$

soit avec $I_C = I_D$

$$\Delta V - V_T \, \mathrm{Log} \, 3 + V_D + \frac{R_{10} - (R_{11} + R_{12})}{2} \, I_C = V_{REF} \qquad (6')$$

En rapprochant les équations (4) et (6'), il vient :

$$(R_{10} + R_{11} + R_{12}) \, I_c = \Delta V - 2 \, V_T \, \mathrm{Log} \, 3 \qquad (7)$$

En utilisant l'équation (2'), on a alors :

$$(R_{11} + R_{12}) I_c = \tfrac{3}{2} \Delta V - 2 V_T \mathrm{Log} 3 - V_c + 2 V_D + E_0 \qquad (8)$$

Les équations (2') et (8) permettent de choisir les valeurs des éléments du circuit d'entrée en fonction à la fois de l'amplitude de commutation $\Delta V$ de l'étage à émetteur couplés et de la valeur centrale de commutation $E_0$ sur la base du transistor $T_3$.

Il est en outre possible de choisir la valeur de l'écart $|V_B - E_0|$ dans le premier et le deuxième état. Cet écart est le même dans ces deux états, car on a choisi un fonctionnement symétrique (voir plus haut).

Dans le premier état, on a :

$$|V_B - E_0| = V_B - E_0 = V_c - 2 V_D - \frac{3}{2} R_{10} I_c - \frac{R_{11} I_c}{2} - E_0$$

En remplaçant $R_{10} I_c$ par sa valeur tirée de (2'), et $V_c - E_O$ par $V_{REF} + V_D$, on obtient :

$$|V_B - E_0| = \frac{V_D}{2} + \frac{3}{4} \Delta V - \frac{V_{REF}}{2} - \frac{R_{11} I_c}{2} \qquad (9)$$

En choisissant la valeur de $R_{11} I_c$, on choisit $|V_B - E_O|$ , donc l'amplitude du signal de commande.

Exemple

$V_{REF} = 1,3V$
$\Delta_V = 600 \, mV$
$I_c = I_D = 250 \mu A$
$V_D = 0,75V$
$R_{10} = 1k\Omega$
$R_{11} = R_{12} = 500\Omega$
$|V_B - E_O| = 112,5mV$

**Revendications**

**1.** Circuit d'entrée de commutation présentant un étage du type à émetteurs couplés (ECL) à deux transistors, à savoir un premier transistor ($T_3$) recevant sur sa base un signal d'entrée et un deuxième transistor ($T_4$) recevant sur sa base un signal de commande, lequel est élaboré par un circuit de commande à partir du signal du collecteur du premier transistor, de manière à obtenir sur le collecteur du deuxième transistor un signal de sortie commutant plus rapidement que le signal d'entrée, dans lequel le circuit de commande comporte un troisième transistor ($T_6$) dont le collecteur est connecté à une source de tension d'alimentation ($V_c$), dont la base est connectée au collecteur du premier transistor ($T_3$) et dont l'émetteur est reliée à une source de courant de référence ($I_c$) dite source principale de courant, via une résistance d'émetteur ($R_{10}$) dite première résistance, caractérisé en ce que le circuit de commande comporte une deuxième ($R_{11}$) et une troisième résistance ($R_{12}$) disposées en série avec la première résistance ($R_{10}$), entre l'émetteur du troisième transistor ($T_6$) et un point de référence (C) auquel sont connectés une source de tension de référence ($U_{REF}$)et une source de courant de référence ($I_D$) dite source annexe de courant, le point (B) commun à la deuxième ($R_{11}$) et à la troisième ($R_{12}$) résistance et délivrant ledit signal de commande étant connecté à la base du deuxième transistor ($T_4$).

2. Circuit selon la revendication 1, caractérisé en ce que la source de tension de référence ($U_{REF}$) comporte un quatrième transistor ($T_7$) dont le collecteur est connecté à la source de tension d'alimentation ($V_c$), dont la base est portée à une tension de référence ($V_c$-$V_{REF}$).

3. Circuit selon une des revendications 1 ou 2, caractérisé en ce qu'il comporte au moins une diode ($T_{10}$) dans le sens direct entre l'émetteur du troisième transistor ($T_6$) et la première résistance ($R_{10}$).

## Claims

1. A switching input circuit, comprising a stage of the emitter coupled logic (ECL) type with two transistors, that is to say a first transistor ($T_3$) receiving an input signal on its base and a second transistor ($T_4$) receiving on its base a control signal which is generated by a control circuit from the signal from the collector of the first transistor in order to obtain on the collector of the second transistor an output signal switching faster than the input signal, the control circuit comprising a third transistor ($T_6$) whose collector is connected to a supply voltage source ($V_c$), whose base is connected to the collector of the first transistor ($T_3$), and whose emitter is connected to a reference current source ($I_c$), referred to as the main current source, via an emitter resistor ($R_{10}$) which is referred to as the first resistor, characterized in that the control circuit comprises a second resistor ($R_{11}$) and a third resistor ($R_{12}$) which are connected, in series with the first resistor ($R_{10}$), between the emitter of the third transistor ($T_6$) and a reference point (C) whereto there are connected a reference voltage source ($U_{REF}$) and a reference current source ($I_D$), referred to as the auxiliary current source, the point (B) common to the second resistor ($R_{11}$) and the third resistor ($R_{12}$) supplying the said control signal and being connected to the base of the second transistor ($T_4$).

2. A circuit as claimed in Claim 1, characterized in that the reference voltage source ($U_{REF}$) comprises a fourth transistor ($T_7$) whose collector is connected to the supply voltage source ($V_c$) and whose base is connected to a reference voltage ($V_c$-$V_{REF}$).

3. A circuit as claimed in any one of Claims 1 or 2, characterized in that it comprises at least one forward biased diode ($T_{10}$) between the emitter of the third transistor ($T_6$) and the first resistor ($R_{10}$).

## Patentansprüche

1. Eingangsschaltkreis mit einer Stufe vom Typ der emittergekoppelten Logik (ECL) mit zwei Transistoren, wobei der erste Transistor ($T_3$) an seiner Basis ein Eingangssignal und der zweite Transistor ($T_4$) an seiner Basis ein Steuersignal empfangen, das von einem Steuerkreis ausgehend vom Kollektorsignal des ersten Transistors derart bearbeitet wird, daß am Kollektor des zweiten Transistors ein Ausgangssignal erhalten wird, das schneller als das Eingangssignal schaltet, wobei der Steuerkreis einen dritten Transistor ($T_6$) enthält, dessen Kollektor mit einer Speisespannungsquelle ($V_c$) verbunden ist, dessen Basis mit dem Kollektor des ersten Transistors ($T_3$) und dessen Emitter über einen als ersten Widerstand bezeichneten Emitterwiderstand ($R_{10}$) mit einer als Hayupstromquelle bezeichneten Bezugsstromquelle ($I_c$) verbunden ist, dadurch gekennzeichnet, daß die Steuerschaltung einen zweiten ($R_{11}$) und einen dritten Widerstand ($R_{12}$) in Reihenschaltung mit dem ersten Widerstand ($R_{10}$) zwischen dem Emitter des dritten Transistors ($T_6$) und einem Bezugspunkt (C) enthält, an den eine Bezugsspannungsquelle ($U_{REF}$) und eine als Nebenstromquelle bezeichnete Bezugsstromquelle ($I_D$) angeschlossen sind, wobei der gemeinsame Punkt (B) des zweiten ($R_{11}$) und des dritten Widerstands ($R_{12}$), der das Steuersignal liefert, mit der Basis des zweiten Transistors ($T_4$) verbunden ist.

2. Schaltkreis nach Anspruch 1, dadurch gekennzeichnet, daß die Bezugsspannungsquelle ($U_{REF}$) einen vierten Transistor ($T_7$) enthält, dessen Kollektor mit der Speisespannungsquelle ($V_c$) verbunden ist, dessen Basis eine Bezugsspannung ($V_c$-$V_{REF}$) führt.

3. Schaltkreis nach einem der Ansprüche 1 oder 2, dadurch gekennzeichnet, daß er wenigstens eine zwischen dem Emitter des dritten Transistors ($T_6$) und dem ersten Widerstand ($R_{10}$) im Vorwärtsrichtung leitende Diode ($T_{10}$) enthält.